# EUROPEAN PATENT APPLICATION

(11) **EP 4 749 674 A1**
(43) Date of publication of application: **27.05.2026**
(21) Application number: 25218246.4
(22) Date of filing: 25.11.2025
(51) Int. Cl.: H01H 71/12, H01H 71/24

(54) **MINIATURE CIRCUIT BREAKER**

(30) Priority: 26.11.2024 CN 202411702186
(71) Applicant: SCHNEIDER ELECTRIC INDUSTRIES SAS, 92500 Rueil-Malmaison (FR)
(72) Inventor: LIU, Zhenzhong, Shanghai, 201203 (CN); YU, Gang, Shanghai, 201203 (CN); TIAN, Simon, Shanghai, 201203 (CN)
(74) Representative: Openshaw & Co.

(57) **Abstract**

A miniature circuit breaker (100) includes a tripping mechanism (10), a magnetic trip assembly (30), and an electronic trip unit (40). The tripping mechanism (10) includes a moving contact support (11), a moving contact (12), and first and second actuation input parts (131,132) which are adapted to drive the moving contact support (11) to move to drive the moving contact (12). The magnetic trip assembly (20) includes a coil (31) and an actuation part (32). When a main circuit current is greater than a first predetermined short-circuit current threshold, the actuation part (32) acts to apply an external force to the first actuation input part (131). The electronic trip unit (40) includes a current sensor (41), a controller (42), and an action actuator (43). The controller (42) is configured to control the action actuator (43) to apply the external force to the second actuation input part (132) in response to the main circuit current being greater than a predetermined overload current threshold and less than a second predetermined short-circuit current threshold.

## Description

### FIELD

Embodiments of the present disclosure relate to the field of electrical equipment, and more particularly to a miniature circuit breaker.

### BACKGROUND

A miniature circuit breaker is a switch used to turn on, carry, and break a current. The miniature circuit breaker can automatically trip upon an occurrence of overload or short circuit in a circuit, thereby providing protection to lines and devices.

Existing miniature circuit breakers usually adopt a combination of a thermal trip assembly and a magnetic trip assembly to achieve overload long-time delay protection and short-circuit protection. The thermal trip assembly includes a bimetallic strip deforming under the influence of the heat generated by the overload current. A tripping mechanism of the miniature circuit breaker is triggered to act when the deformation of the bimetallic strip reaches a certain level, causing a moving contact of the tripping mechanism to be separated from a fixed contact, thereby breaking the current. The magnetic trip assembly includes a coil and an iron core (also referred to as an actuation part) sleeved in the coil. When the short circuit occurs, a magnetic field generated by the coil can drive the iron core to move. The iron core further triggers the tripping mechanism to act so as to separate the moving contact of the tripping mechanism from the fixed contact, thereby breaking the current. During operation of such miniature circuit breaker, the thermal trip assembly exhibits high temperature rise, large heat generation, and high power consumption, thus posing potential safety hazards.

Currently, some miniature circuit breakers adopt an electronic trip unit to replace the combination of the thermal trip assembly and the magnetic trip assembly. Specifically, the electronic trip unit can detect a main circuit current, and compare the main circuit current with a plurality of predetermined current thresholds. When the overload current or the short-circuit current is indicated according to the comparison result, the electronic trip unit triggers the tripping mechanism to act so as to break the current. In order to give consideration to functions such as overload long-time delay protection, short-circuit short-time delay protection, instantaneous protection, the electronic trip unit usually requires a high-precision sensor as well as a controller and an action actuator matched therewith, which results in a relatively high cost of the electronic trip unit.

### SUMMARY

It is an object of the present disclosure to provide a miniature circuit breaker to at least partially solve the above problems.

The present disclosure provides a miniature circuit breaker, including a tripping mechanism, a magnetic trip assembly, and an electronic trip unit. The tripping mechanism includes a moving contact support, at least one moving contact disposed on the moving contact support, and a first actuation input part and a second actuation input part which are respectively operatively connected to the moving contact support. When any of the first actuation input part and the second actuation input part is actuated by an external force, the moving contact support is driven to move, so that the at least one moving contact is separated from a corresponding fixed contact. The magnetic trip assembly includes a coil and an actuation part. The coil is electrically connected to the fixed contact, and when a main circuit current flowing through the miniature circuit breaker is greater than a first predetermined short-circuit current threshold, the actuation part acts under the action of an electromagnetic field generated by the coil so as to apply the external force to the first actuation input part. The electronic trip unit includes a current sensor, a controller, and an action actuator. The current sensor is configured to measure a magnitude of the main circuit current, and the controller is configured to control the action actuator to act in response to the main circuit current being greater than a predetermined overload current threshold and less than a second predetermined short-circuit current threshold, so that the action actuator applies the external force to the second actuation input part. The first predetermined short-circuit current threshold is greater than the second predetermined short-circuit current threshold.

In some embodiments, the controller is further configured to: in response to the main circuit current being greater than the second predetermined short-circuit current threshold and less than the first predetermined short-circuit current threshold, control the action actuator to apply the external force to the second actuation input part.

In some embodiments, in response to the main circuit current being greater than the second predetermined short-circuit current threshold and less than the first predetermined short-circuit current threshold, the actuation part acts under the action of the electromagnetic field generated by the coil, so as to apply the external force to the first actuation input part.

In some embodiments, the first predetermined short-circuit current threshold is greater than or equal to 1 kA.

In some embodiments, the moving contact support is provided with two moving contacts spaced apart from each other, the two moving contacts are respectively matched with two fixed contacts. The miniature circuit breaker further includes two arc extinguishing chambers, and each of the arc extinguishing chambers is matched with the corresponding moving contact and fixed contact.

In some embodiments, the moving contact support separates the moving contact from the fixed contact through translational movement, or the moving contact support separates the moving contact from the fixed contact through rotational movement.

In some embodiments, the moving contact support is provided with two moving contacts spaced apart from each other, the two moving contacts are respectively matched with two fixed contacts. The two fixed contacts include a first fixed contact and a second fixed contact, the first fixed contact is electrically connected to an inlet terminal of the miniature circuit breaker, and the second fixed contact is electrically connected to an outlet terminal of the miniature circuit breaker. One of the current sensor and the coil is arranged between the first fixed contact and the inlet terminal, and the other of the current sensor and the coil is arranged between the second fixed contact and the outlet terminal.

In some embodiments, the moving contact support is provided with two moving contacts spaced apart from each other, the two moving contacts are respectively matched with two fixed contacts. The two fixed contacts include a first fixed contact and a second fixed contact, the first fixed contact is electrically connected to an inlet terminal of the miniature circuit breaker, and the second fixed contact is electrically connected to an outlet terminal of the miniature circuit breaker. The current sensor and the coil are both arranged between the first fixed contact and the inlet terminal, or the current sensor and the coil are both arranged between the second fixed contact and the outlet terminal.

In some embodiments, when the main circuit current is greater than the first predetermined short-circuit current threshold, the magnetic trip assembly drives the moving contact to be separated from the fixed contact within a first trip delay time. When the main circuit current is greater than the predetermined overload current threshold and less than the first predetermined short-circuit current threshold, the electronic trip unit drives the moving contact to be separated from the fixed contact within a second trip delay time. The second trip delay time is greater than the first trip delay time.

In some embodiments, the miniature circuit breaker further includes a communication module adapted to send operating parameters of the miniature circuit breaker to the outside.

In some embodiments, the miniature circuit breaker further includes a housing in which the tripping mechanism, the fixed contact, the magnetic trip assembly, the electronic trip unit, and the communication module are disposed. The housing is provided with a manual switch operatively connected to the moving contact support and adapted to drive the moving contact to be separated from or abutted against the fixed contact.

In embodiments according to the present disclosure, the miniature circuit breaker achieves overload protection and short-circuit protection through a combination of the magnetic trip assembly and the electronic trip unit, which allows the magnetic trip assembly to focus on quickly breaking of a relatively high short-circuit current regardless of the constraints of a relatively low short-circuit current, as well as allows the electronic trip unit to meet breaking requirements to be required through adopting low cost components. Therefore, on the one hand, the miniature circuit breaker can accurately measure current, facilitating precise control of the relationship between current and trip delay time (that is, precise breaking control), and has low heat generation. On the other hand, the miniature circuit breaker can instantaneously trip when a high short-circuit current occurs. The miniature circuit breaker is enabled to achieve a better breaking effect, the power consumption is reduced, and the cost can be controlled within a proper range.

It should be understood that the content described in this content section is not intended to limit the key features or important features of the embodiments of the present disclosure, nor is it intended to limit the scope of the present disclosure. Other features of the present disclosure will become readily understood from the following description.

### BRIEF DESCRIPTION OF DRAWINGS

The above and other features, advantages, and aspects of various embodiments of the present disclosure will become more apparent from the following detailed description taken in conjunction with the accompanying drawings. In the drawings, the same or similar reference numbers refer to the same or similar elements, wherein:
FIG. 1 shows a schematic structural diagram of a miniature circuit breaker according to an embodiment of the present disclosure;
FIG. 2 shows a trip curve of a miniature circuit breaker according to an embodiment of the present disclosure;
FIG. 3 shows a schematic structural diagram of a miniature circuit breaker according to another embodiment of the present disclosure; and
FIG. 4 shows a block diagram of a miniature circuit breaker according to a further embodiment of the present disclosure.

### DETAILED DESCRIPTION

Embodiments of the present disclosure will be described in more detail below with reference to the accompanying drawings. While the embodiments of the present disclosure are shown in the drawings, it should be understood that the present disclosure may be implemented in various forms and should not be limited by embodiments set forth herein. Rather, these embodiments are provided to make this disclosure more thorough and complete, and to fully convey the scope of the present disclosure to those skilled in the art.

As used herein, the term "including" and variations thereof represent openness, i.e., "including but not limited to". Unless specifically stated, the term "or" means "and/or". The term "based on" means "based at least in part on". The terms "an example embodiment" and "an embodiment" mean "at least one example embodiment". The term "another embodiment" means "at least one further embodiment". The terms "first", "second", and the like may refer to different or identical objects.

As described above, current miniature circuit breakers break current mainly in two ways: one is to break the current by a combination of a thermal trip assembly and a magnetic trip assembly, and the other is to break the current by using an electronic trip.

For a miniature circuit breaker with the combination of the thermal trip assembly and the magnetic trip assembly, its overload protection is mainly achieved through the thermal trip assembly, while low-current short-circuit protection and high-current short-circuit protection are mainly achieved through the magnetic trip assembly.

Specifically, the thermal trip assembly includes a bimetallic strip that can deform upon being heated. When the bimetallic strip deforms to a certain level due to being heated, it can drive an actuation input part of the tripping mechanism, and further triggers the tripping mechanism to act, so as to separate the moving contact from the fixed contact. In order to prevent the bimetallic strip from overheating in a short time when carrying overload current and ensure that it can trigger the tripping mechanism to act after thermal deformation, a size (for example, a cross-sectional area) of the bimetallic strip is generally relatively large. The large size of the bimetallic strip results in large sizes and weights of matching structures such as the moving contact and the fixed contact. As a result, on the one hand, the miniature circuit breaker has high power consumption and high electricity usage, which conflicts with user's requirements for low power consumption and low carbon emissions of the miniature circuit breaker. On the other hand, the bimetallic strip exhibits a relatively large temperature rise during operation, which poses potential safety hazards.

The magnetic trip assembly includes a coil and an actuation part sleeved in the coil. A magnetic field generated by the coil during a short circuit can drive the actuation part to move. The actuation part then drives another actuation input part of the tripping mechanism, and further triggers the tripping mechanism, so as to separate the moving contact from the fixed contact. For the magnetic trip assembly, it is required to not only act within a certain trip delay time when a low short-circuit current occurs, but also act within a shorter trip delay time when a high short-circuit current occurs. Thus, the performance requirement on the magnetic trip assembly is relatively high.

In addition, when the miniature circuit breaker is in a state of turning on the current, in order to ensure a reliable contact between the moving contact and the fixed contact with relatively large sizes, the moving contact with a relatively heavy weight is biased on the fixed contact, and a relatively large contact pressure is formed between the moving contact and the fixed contact. Therefore, the moving contact not only has the relatively heavy weight but also bears the relatively large contact pressure, which results in the need for a relatively large force and a relatively long time to separate the moving contact from the fixed contact when the current needs to be broken, thereby causing the breaking speed of the miniature circuit breaker to be affected, and the selective protection of upper-level and lower-level circuits cannot be provided.

For a miniature circuit breaker with an electronic trip unit, in order to realize functions such as overload long-time delay protection, short-circuit short-time delay protection, and instantaneous protection, the electronic trip unit is required to adopt a high-precision sensor as well as a controller and an action actuator matched therewith. The cost of the electronic trip unit is therefore relatively high. In addition, during operation of the electronic trip unit, the time required from detecting an abnormal current (for example, a short-circuit current) to determining the current abnormality, and then to controlling the action actuator to act so as to trip the tripping mechanism is relatively long (that is, the trip delay time is relatively long). Especially when a high short-circuit current occurs, the instantaneous protection effect is not ideal enough.

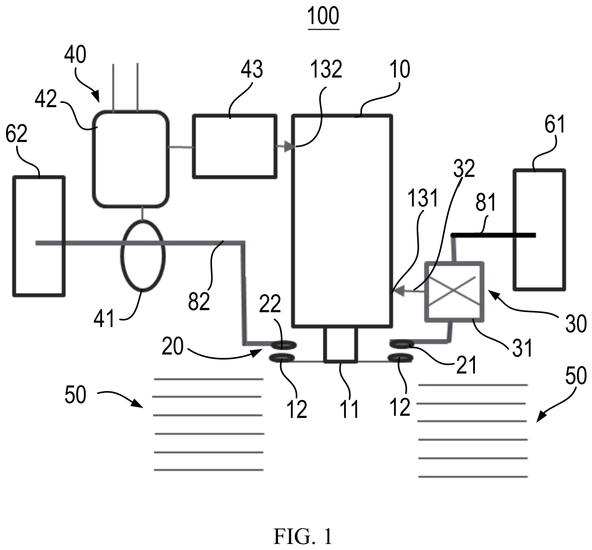

Embodiments of the present disclosure provide a miniature circuit breaker with low power consumption, precise breaking control, good breaking effect and relatively low cost, which can solve at least a part of the problems existing in the aforementioned miniature circuit breakers. Hereinafter, the principle of the present disclosure will be described with reference to FIGS. 1 to 4.

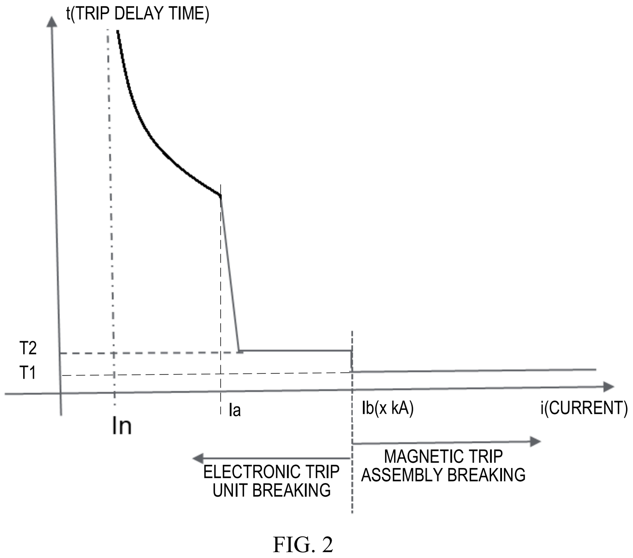

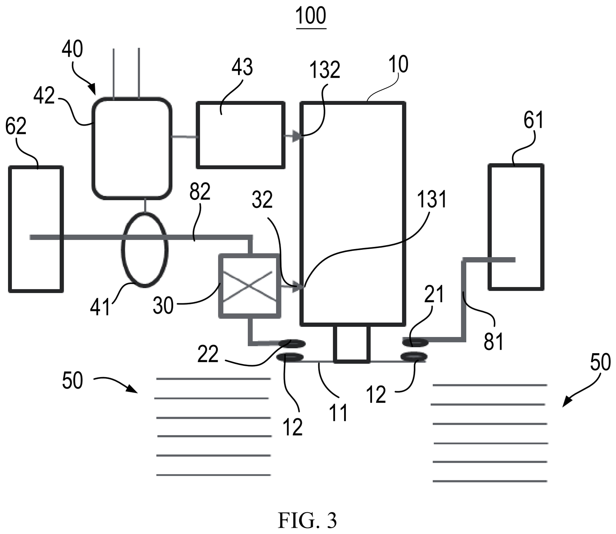

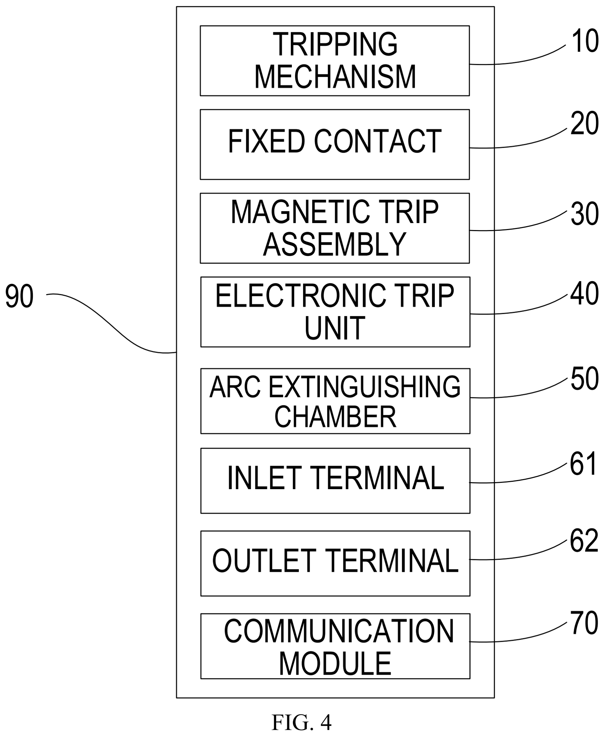

FIG. 1 shows a schematic structural diagram of a miniature circuit breaker 100 according to an embodiment of the present disclosure. FIG. 2 shows a trip curve of the miniature circuit breaker 100 according to an embodiment of the present disclosure. The trip curve may be a B type, a C type or a D type trip curve. FIG. 3 shows a schematic structural diagram of the miniature circuit breaker 100 according to another embodiment of the present disclosure. FIG. 4 shows a block diagram of the miniature circuit breaker 100 according to a further embodiment of the present disclosure.

Referring to FIG. 1, the miniature circuit breaker 100 includes at least a tripping mechanism 10, a fixed contact 20, a magnetic trip assembly 30, and an electronic trip unit 40. Combined with the related technology, it can be seen that the miniature circuit breaker 100 may further include a housing 90 (not shown in FIG. 1; see FIG. 4), and the tripping mechanism 10, the fixed contact 20, the magnetic trip assembly 30, and the electronic trip unit 40 are all installed in the housing 90. The housing 90 may further be provided with an inlet terminal 61, an outlet terminal 62, an arc extinguishing chamber 50, and the like. The inlet terminal 61 is adapted to be connected to a power supply, and the outlet terminal 62 is adapted to be connected to a load.

Referring to FIG. 1, the tripping mechanism 10 includes a moving contact support 11, at least one moving contact 12, a first actuation input part 131, and a second actuation input part 132. At least one fixed contact 20 is correspondingly disposed in the housing 90.

The moving contact 12 is disposed on the moving contact support 11, and the moving contact 12 may move along with the moving contact support 11 so as to abut against or be separated from a corresponding fixed contact 20. When the moving contact 12 abuts against the fixed contact 20, the inlet terminal 61 is connected to the outlet terminal 62 through a conductor 81, the fixed contact 20, the moving contact support 11, the moving contact 12, and a conductor 82. When the moving contact 12 is separated from the fixed contact 20, a circuit between the inlet terminal 61 and the outlet terminal 62 is broken. An arc generated when the moving contact 12 is separated from the fixed contact 20 can be quickly introduced into the extinguishing chamber 50 to be extinguished.

The first actuation input part 131 and the second actuation input part 132 are respectively operatively connected to the moving contact support 11. When any of the first actuation input part 131 and the second actuation input part 132 is actuated by an external force, the moving contact support 11 can be driven to move, so that the moving contact 12 is separated from a corresponding fixed contact 20. The process in which the tripping mechanism 10 acts under the external force to separate the moving contact 12 from the fixed contact 20 may also be referred to as the tripping mechanism 10 performing a trip action, thereby breaking the current.

In some embodiments, a manual switch may be installed on the housing 90, and the manual switch is operatively connected to the moving contact support 11 and adapted to drive the moving contact support 11 to move, enabling the moving contact 12 to be separated from or abut against the fixed contact 20.

In some embodiments, the tripping mechanism 10 may refer to a tripping mechanism used to be matched with the thermal trip assembly and the magnetic trip assembly in the related art, and the tripping mechanism in the related art includes two actuation input parts, which can receive external forces from different sources (bimetallic strip and iron core), drive the moving contact support to act, and separate the moving contact from the fixed contact. Of course, the implementation forms of the tripping mechanism 10 according to embodiments of the present disclosure are not limited thereto, as long as they can achieve the purpose of the present disclosure.

With continued reference to FIG. 1, in this embodiment, the magnetic trip assembly 30 may include a coil 31 and an actuation part 32. The coil 31 is electrically connected to the fixed contact 20, and the coil 31 serves as a part of a circuit (also referred to as a main circuit of the miniature circuit breaker 100) connecting the inlet terminal 61 and the outlet terminal 62. The actuation part 32 corresponds to the first actuation input part 131 of the tripping mechanism 10, and the actuation part 32 is adapted to apply the external force to the first actuation input part 131 to move the moving contact support 11. That is, the actuation part 32 triggers the tripping mechanism 10 to automatically perform a trip action by applying the external force to the first actuation input part 131, so as to break the current. The actuation part 32 may be, for example, an iron core sleeved in the coil 31. Of course, the implementation of the actuation part 32 is not limited thereto.

With reference to FIG. 1 and FIG. 2, when the main circuit current flowing through the miniature circuit breaker 100 is greater than or equal to a first predetermined short-circuit current threshold Ib, the electromagnetic field generated by the coil 31 of the magnetic trip assembly 30 causes the actuation part 32 to act. The actuation part 32 then applies the external force to the first actuation input part 131 and drives the moving contact 12 to be separated from the fixed contact 20 within a first trip delay time T1, and the main circuit current is automatically broken. Therefore, in embodiments of the present disclosure, the magnetic trip assembly 30 may be dedicated to breaking the short-circuit current with a relatively high current level.

The electronic trip unit 40 may include a current sensor 41, a controller 42, and an action actuator 43. The current sensor 41 is configured to measure a magnitude of the main circuit current of the miniature circuit breaker 100 and send the information of the main circuit current to the controller 42. The controller 42 determines whether to control the action actuator 43 to act based on received information about the magnitude of the main circuit current sent by the current sensor 43. The action actuator 43 corresponds to the second actuation input part 132 of the tripping mechanism 10, and it is adapted to apply the external force to the second actuation input part 132 to move the moving contact support 11. That is, by applying the external force to the second actuation input part 132, the action actuator 43 triggers the tripping mechanism 10 to automatically perform the trip action, so as to break the current.

In some embodiments, in response to the main circuit current being greater than a predetermined overload current threshold and less than a second predetermined short-circuit current threshold Ia, the controller 42 controls the action actuator 43 to act such that the action actuator 43 applies the external force to the second actuation input part 132, so that the main circuit current is automatically broken. The second predetermined short-circuit current threshold Ia is less than the first predetermined short-circuit current threshold Ib. Therefore, the electronic trip unit 40 may at least break the overload current. It should be noted that the predetermined overload current threshold is related to a rated current In, and according to different standards of the miniature circuit breakers, a multiple relationship between the predetermined overload current threshold and the rated current In varies.

As can be seen from the above, when the main circuit of the miniature circuit breaker 100 is overloaded, the main circuit current is greater than or equal to the predetermined overload current threshold. In addition, according to the magnitude of the main circuit current during a short circuit of the miniature circuit breaker 100, main circuit current can be classified into a first short-circuit current or a second short-circuit current, and the second short-circuit current is higher than the first short-circuit current. In some embodiments, the second predetermined short-circuit current threshold Ia is between the overload current and the first short-circuit current. The first short-circuit current may be referred to as a low short-circuit current, and the second predetermined short-circuit current threshold Ia may be referred to as a low short-circuit current threshold. The first predetermined short-circuit current threshold Ib is between the first short-circuit current and the second short-circuit current, the second short-circuit current may be referred to as a high short-circuit current, and the first predetermined short-circuit current threshold Ib may be referred to as a high short-circuit current threshold.

In some embodiments, the electronic trip unit 40 may further be adapted to break the low short-circuit current with a relatively low current. Specifically, in response to the main circuit current being greater than or equal to the second predetermined short-circuit current threshold Ia, and less than the first predetermined short-circuit current threshold Ib, the controller 42 controls the action actuator 43 to act, so that the action actuator 43 applies the external force to the second actuation input part 132, causing the main circuit current to be automatically broken.

More specifically, the controller 42 of the electronic trip unit 40 includes a PCBA (integrated printed circuit board assembly) with an adjustable setting value. The current sensor 41 may be a current sampling coil. When the current sensor 41 detects that the main circuit current is not less than the predetermined overload current threshold, and less than the first predetermined short-circuit current threshold Ib, the PCBA sends an instruction to cause the action executor 43 to apply the external force to the second actuation input part 132.

The miniature circuit breaker 100 provided by embodiments of the present disclosure achieves overload protection and short-circuit protection through a combination of the magnetic trip assembly 30 and the electronic trip unit 40, which allows the magnetic trip assembly 30 to focus on fast breaking of a relatively high short-circuit current regardless of the constraints of a relatively low short-circuit current, as well as allows the electronic trip unit 40 to meet breaking requirements of overload current and low short-circuit current through adopting low cost components. Therefore, on the one hand, the miniature circuit breaker 100 according to embodiments of the present disclosure can accurately measure current, facilitating precise control of the relationship between current and trip delay time (that is, precise breaking control), and has low heat generation. On the other hand, the miniature circuit breaker 100 can instantaneously trip when a high short-circuit current occurs. As such, the miniature circuit breaker 100 is enabled to achieve a better breaking effect, the power consumption is reduced, and the cost can be controlled within a proper range.

In some alternative embodiments, the electronic trip unit 40 may only be used to break the overload current, and the magnetic trip assembly 30 is used to break the low and high short-circuit currents. That is, in response to the main circuit current being greater than or equal to the second predetermined short-circuit current threshold Ia, and less than the first predetermined short-circuit current threshold Ib, the actuation part 32 of the magnetic trip assembly 30 can act under the action of the electromagnetic field generated by the coil 31 so as to apply the external force to the first actuation input part 131, so that the main circuit current is automatically broken.

Since the miniature circuit breaker 100 provided by embodiments of the present disclosure does not require the use of the bimetallic strip, the temperature rise limitation of the circuit of the miniature circuit breaker is greatly relieved, and the design of the matching structures such as the moving contact 12 and the fixed contact 20 and the design of the arc extinguishing chamber 50 can be optimized. For example, both the sizes and weights of the moving contact 12 and the fixed contact 20 may be reduced. In this way, not only is the contact pressure between the moving contact 12 and the fixed contact 20 reduced, but also the weight of the whole miniature circuit breaker 100 is reduced. Further, when it is necessary to break the current, the moving contact 12 with small weight and subject to a relatively low contact pressure can be opened earlier and faster to move away from the fixed contacts 20.

With reference to FIGS. 1 and 2, in this embodiment, when the circuit where the miniature circuit breaker 100 is located is short-circuited and the main circuit current is greater than or equal to the first predetermined short-circuit current threshold Ib, the main circuit current is defined as the high short-circuit current. Correspondingly, when the circuit where the miniature circuit breaker 100 is located is short-circuited (that is, the main circuit current is greater than or equal to the second predetermined short-circuit current threshold Ia) and the main circuit current is less than the first predetermined short-circuit current threshold Ib, the main circuit current is defined as the low short-circuit current. As can be seen from FIG. 2, when the main circuit current is the high short-circuit current, the electronic trip unit 40 does not act, and the magnetic trip assembly 30 achieves instantaneous breaking of the high short-circuit current. When the main circuit current is an overload current or a low short-circuit current, the electronic trip unit 40 achieves long-time delay breaking of the overload current and short-time delay breaking of the low short-circuit current. That is, when the main circuit current is the overload current or the low short-circuit current lower than the first predetermined short-circuit current threshold Ib, the magnetic trip assembly 30 does not act, and the action executor 43 of the electronic trip unit 40 applies the external force to the second actuation input part 132 to separate the moving contact 12 from the fixed contact 20.

In some embodiments, the aforementioned first predetermined short-circuit current threshold Ib may be, for example, a high short-circuit current of x kA, where x is greater than or equal to 1. In some embodiments, the first predetermined short-circuit current threshold Ib may be, for example but not limited to, 1 kA, 5 kA, 10 kA, or the like. It should be understood that according to different application environments of the miniature circuit breakers, the first predetermined short-circuit current threshold Ib may be, for example, other values, or may be less than 1 kA.

In the related art, when the electronic trip unit is adopted to achieve overload protection, low-current short-circuit protection and high-current short-circuit protection, in order to meet the requirement for instantaneous breaking of high short-circuit current, while considering factors such as magnetic saturation phenomenon of the current sensor, the speed of the controller and the action actuator, relatively high requirements are imposed on the current sensor, the controller, and the action actuator. This results in very high costs for the electronic trip unit and the miniature circuit breaker.

In embodiments of the present disclosure, the electronic trip unit 40 is adapted to achieve overload protection and low-current short-circuit protection, but not high-current short-circuit protection. As such, the electronic trip unit 40 does not have to take into account constraints related to the requirements for instantaneous breaking in high-current short-circuit protection, which greatly simplifies the complexity of its own design. At the same time, the electronic trip unit 40 can use components such as the current sensor 41 and the an action actuator 43 with relatively low costs, thereby significantly reducing the cost of the electronic trip unit 40.

Meanwhile, the magnetic trip assembly 30 is adapted to achieve high-current short-circuit protection but not low-current short-circuit protection, thus eliminating the limitation of needing to balance the instantaneous breaking for high short-circuit current and short-time breaking for the low short-circuit current. Its high short-circuit current breaking capacity can therefore be better optimized. This helps the magnetic trip assembly 30, when a high short-circuit current occurs, to drive the moving contact support 11 of the tripping mechanism 10 to act earlier and faster, enabling the moving contact 12 to be quickly separated from the fixed contact 20.

In addition, it should be noted that, in embodiments of the present disclosure, the setting value of the PCBA of the electronic trip unit 40 is adjustable, so that the trip curve is adjustable. In this way, by adjusting the setting value of the PCBA, the requirements for rated current and the trip curve of different types of miniature circuit breakers can be met. On one hand, it can significantly reduce the types of material to be prepared, and on the other hand, it enables the circuit breakers to comply with different circuit breaker standards, making it applicable to various operating environments (for example, it can be used for civil and industrial).

Referring to FIG. 2, a horizontal axis i in FIG. 2 represents the main circuit current of the miniature circuit breaker 100, and a vertical axis t represents the trip delay time of the miniature circuit breaker 100. More specifically, the vertical axis t indicates the duration required from the occurrence of an abnormality in the main circuit current to the automatic breaking of the main circuit current.

As can be seen from FIG. 2, when the miniature circuit breaker 100 operates normally, the main circuit current is not greater than the predetermined overload current threshold, and the miniature circuit breaker 100 does not automatically break the current.

When the circuit where the miniature circuit breaker 100 is located is overloaded, if the main circuit current is the overload current that is not less than the predetermined overload current threshold, and less than the second predetermined short-circuit current threshold Ia, the electronic trip unit 40 achieves automatic breaking current with a long-time delay.

When the circuit where the miniature circuit breaker 100 is located is short-circuited, if the main circuit current is the first short-circuit current that is greater than or equal to the second predetermined short-circuit current threshold Ia, and less than the first predetermined short-circuit current threshold Ib, the electronic trip unit 40 realizes automatic breaking current with a short-time delay. For example, according to the magnitude of the current, the electronic trip unit 40 drives the moving contact 12 to be separated from the fixed contact 20 at least within a second trip delay time T2, so as to automatically break the current. For example, T2 may be, but is not limited to, 10 ms. For example, T2 may be less than 10 ms.

When the circuit where the miniature circuit breaker 100 is located is short-circuited, if the main circuit current is the second short-circuit current greater than or equal to the first predetermined short-circuit current threshold Ib, the magnetic trip assembly 30 can instantaneously automatically break the current. For example, the magnetic trip assembly 30 may drive the moving contact 12 to be separated from the fixed contact 20 within a first trip delay time T1, so as to automatically break the current. The time T1 is less than T2. In some embodiments, T1 may be as low as 2 ms.

Referring back to FIG. 1, in some embodiments, the moving contact support 11 is provided with two moving contacts 12 spaced apart from each other, two fixed contacts 20 are correspondingly disposed in the housing 90, and the two moving contacts 12 are respectively matched with the two fixed contacts 20. The two fixed contacts 20 include a first fixed contact 21 and a second fixed contact 22. The first fixed contact 21 is electrically connected to the inlet terminal 61 of the miniature circuit breaker 100, and the second fixed contact 22 is electrically connected to the outlet terminal 62 of the miniature circuit breaker 100. When a high short-circuit current occurs, each of the moving contacts 12 can be separated from the corresponding fixed contact earlier and more quickly under the drive of the actuation part of the magnetic trip assembly 30 and the electrodynamic repulsion force between the two pairs of moving contacts 12 and fixed contacts 20. In this way, the miniature circuit breaker 100 provided by embodiments of the present disclosure can open the moving contacts 12 earlier and faster than the miniature circuit breakers in the prior art.

As can be seen from FIG. 1, the miniature circuit breaker 100 further includes two arc extinguishing chambers 50, and each of the arc extinguishing chambers 50 is matched with a corresponding pair of moving contact 12 and fixed contact 20 to obtain a higher arc voltage.

In some embodiments, the moving contact support 11 may separate the moving contact 12 from the corresponding fixed contact 20 through translational movement. In some embodiments, the moving contact support 11 may separate the moving contact 12 from the corresponding fixed contact 20 through rotational movement.

Referring to FIG. 1, in some embodiments, the coil 31 is arranged on a circuit between the first fixed contact 21 and the inlet terminal 61. That is, the coil 31 is connected in series with the conductor 81 that connects the first fixed contact 21 and the inlet terminal 61. The current sensor 41 is arranged between the second fixed contact 22 and the outlet terminal 62. That is, the current sensor 41 obtains the main circuit current by sensing the current flowing through the conductor 82. Of course, in some alternative embodiments, the current sensor 41 may be arranged on a circuit between the first fixed contact 21 and the inlet terminal 61, and the coil 31 may be arranged between the second fixed contact 22 and the outlet terminal 62 (i.e., connected in series with the conductor 82 that connects the second fixed contact 22 and the outlet terminal 62).

Referring to FIG. 3, in some alternative embodiments, both the current sensor 41 and the coil 31 may be arranged between the second fixed contact 22 and the outlet terminal 62. More specifically, the current sensor 41 obtains the main circuit current by sensing the current flowing through the conductor 82, and the coil 31 is connected in series with conductor 82. Alternatively, in some alternative embodiments, both the current sensor 41 and the coil 31 may be arranged between the first fixed contact 21 and the inlet terminal 61. More specifically, the current sensor 41 obtains the main circuit current by sensing the current flowing through the conductor 81, and the coil 31 is connected in series with conductor 81.

Referring to FIG. 4, in some embodiments, the miniature circuit breaker 100 further includes a communication module 70 installed in the housing 90. The communication module 70 is configured to send operating parameters of the miniature circuit breaker 100 to the outside, which provides a possibility for the intelligent application of the miniature circuit breaker 100. For example, the communication module 70 may send information such as current and voltage to a user terminal or a server, etc., in a wireless or wired manner, and may be configured to achieve current monitoring, metering, communication, remote control, and the like of the miniature circuit breaker 100.

The following takes a C type trip curve with a rated current of 20A as an example. The breaking capacity of the miniature circuit breaker 100 according to embodiments of the present disclosure in practical applications is described below.

When the main circuit current of the circuit breaker 100 does not exceed the predetermined overload threshold, the miniature circuit breaker 100 carries the current for a long time without automatic trip.

When the main circuit current is an overload current of 30A, the miniature circuit breaker 100 performs a delayed trip.

When the main circuit current is a low short-circuit current of 300A, the miniature circuit breaker 100 performs a fast trip, and the trip delay time is, for example, about 10 ms.

When the main circuit current exceeds 1 kA, the miniature circuit breaker 100 performs a trip at a faster speed, thereby quickly breaking the short-circuit current. For example, when the main circuit current reaches 10 kA, the trip delay time will be less than 2 ms, which is much shorter than 10 ms.

In contrast, in the related art, when the miniature circuit breaker adopting the combination of the thermal trip assembly and the magnetic trip assembly has a trip delay time about 4.5 ms when breaking a high short-circuit current of 10 kA. While the miniature circuit breaker adopting the electronic trip unit in the related art has a trip delay time longer than 4.5 ms when breaking the high short-circuit current of 10 kA.

In some embodiments, for example, when a short circuit with a prospective short-circuit current as high as 50 kA occurs, the short-circuit current flowing through the circuit breaker 100 provided by embodiments of the present disclosure can quickly repel the two moving contacts 12 from the corresponding fixed contacts 20. Meanwhile, the magnetic trip assembly 30 also quickly drives the tripping mechanism 10 to trip, combined with favorable factors such as the small weight of the moving contact 12, so that the ultra-high short-circuit current can be limited in a very short time (for example, the moving contacts are separated from the fixed contacts within 1 ms, the short-circuit current is limited to below 10 kA), and then the arc is rapidly extinguished (for example, with 2 ms). In this way, the miniature circuit breaker in the related art can be used as the upper-level circuit, with their trip delay time designed to be longer than 2 ms. Thus, together with the miniature circuit breaker provided by embodiments of the present disclosure, the selective protection of the upper-level and lower-level circuits can be achieved.

In summary, the miniature circuit breaker 100 provided by embodiments of the present disclosure does not adopt the thermal trip assembly which can deform upon being heated. On the one hand, the design of the matching structures such as the moving contact 12 and the fixed contact 20, and the design of the arc extinguishing chamber 50 can be optimized, the weight and the contact pressure of the moving contact 12 can be reduced. On the other hand, the power consumption and the temperature rise limitation of the miniature circuit breaker 100 are reduced. The miniature circuit breaker 100 adopts the design of dual moving contacts 12, dual fixed contacts 20, and dual arc extinguishing chambers 50, which not only can open the moving contact 12 as early and quickly as possible, but also increase the arc voltage. The miniature circuit breaker 100 achieves overload protection and short-circuit protection through the combination of the magnetic trip assembly 30 and the electronic trip unit 40, which allows the magnetic trip assembly 30 to focus on fast breaking of a relatively high short-circuit current regardless of the constraints of a relatively low short-circuit current, as well as allows the electronic trip unit 40 to meet breaking requirements of overload current and low short-circuit current through adopting low cost components. Therefore, on the one hand, the miniature circuit breaker 100 can accurately measure current, facilitating precise control of the relationship between current and trip delay time (that is, precise breaking control), and has low heat generation. On the other hand, the miniature circuit breaker 100 can instantaneously trip when a high short-circuit current occurs. As such, the miniature circuit breaker 100 is enabled to achieve a better breaking effect, the power consumption is reduced, and the cost can be controlled within a proper range.

Various embodiments of the present disclosure have been described above, which are illustrative, not exhaustive, and are not limited to embodiments disclosed. Many modifications and variations will be apparent to those of ordinary skill in the art without departing from the scope of the illustrated embodiments. The selection of the terms used herein is intended to best explain the principles of embodiments, practical applications, or technical improvements in the marketplace, or to enable others of ordinary skill in the art to understand embodiments disclosed herein.

## Claims

1. A miniature circuit breaker (100), comprising:
a tripping mechanism (10) comprising a moving contact support (11), at least one moving contact (12) disposed on the moving contact support (11), and a first actuation input part (131) and a second actuation input part (132) which are respectively operatively connected to the moving contact support (11), wherein when any of the first actuation input part (131) and the second actuation input part (132) is actuated by an external force, the moving contact support (11) is driven to move, so that the at least one moving contact (12) is separated from a corresponding fixed contact (20);
a magnetic trip assembly (30) comprising a coil (31) and an actuation part (32), wherein the coil (31) is electrically connected to the fixed contact (20), and when a main circuit current flowing through the miniature circuit breaker (100) is greater than a first predetermined short-circuit current threshold (Ib), the actuation part (32) acts under the action of an electromagnetic field generated by the coil (31) so as to apply the external force to the first actuation input part (131); and
an electronic trip unit (40) comprising a current sensor (41), a controller (42), and an action actuator (43), wherein the current sensor (41) is configured to measure a magnitude of the main circuit current, and the controller (42) is configured to control the action actuator (43) to act in response to the main circuit current being greater than a predetermined overload current threshold and less than a second predetermined short-circuit current threshold (Ia), so that the action actuator (43) applies the external force to the second actuation input part (132), wherein the first predetermined short-circuit current threshold (Ib) is greater than the second predetermined short-circuit current threshold (Ia).

2. The miniature circuit breaker (100) of claim 1, wherein the controller (42) is configured to, in response to the main circuit current being greater than the second predetermined short-circuit current threshold (Ia) and less than the first predetermined short-circuit current threshold (Ib), control the action actuator (43) to apply the external force to the second actuation input part (132).

3. The miniature circuit breaker (100) of claim 1, wherein in response to the main circuit current being greater than the second predetermined short-circuit current threshold (Ia) and less than the first predetermined short-circuit current threshold (Ib), the actuation part (32) acts under the action of the electromagnetic field generated by the coil (31), so as to apply the external force to the first actuation input part (131).

4. The miniature circuit breaker (100) of any of claims 1 to 3, wherein the first predetermined short-circuit current threshold (Ib) is greater than or equal to 1 kA.

5. The miniature circuit breaker (100) of any of claims 1 to 4, wherein:
the moving contact support (11) is provided with two moving contacts (12) spaced apart from each other, the two moving contacts (12) being respectively matched with two fixed contacts (20), and
the miniature circuit breaker (100) comprises two arc extinguishing chambers (50), and each of the arc extinguishing chambers (50) is matched with the corresponding moving contact (12) and fixed contact (20).

6. The miniature circuit breaker (100) of any of claims 1 to 5, wherein the moving contact support (11) separates the moving contact (12) from the fixed contact (20) through translational movement, or the moving contact support (11) separates the moving contact (12) from the fixed contact (20) through rotational movement.

7. The miniature circuit breaker (100) of any of claims 1 to 6, wherein:
the moving contact support (11) is provided with two moving contacts (12) spaced apart from each other, the two moving contacts (12) being respectively matched with two fixed contacts (20), and wherein the two fixed contacts (20) comprise a first fixed contact (21) and a second fixed contact (22), the first fixed contact (21) being electrically connected to an inlet terminal (61) of the miniature circuit breaker (100), and the second fixed contact (22) being electrically connected to an outlet terminal (62) of the miniature circuit breaker (100); and
one of the current sensor (41) and the coil (31) is arranged between the first fixed contact (21) and the inlet terminal (61), and the other of the current sensor (41) and the coil (31) is arranged between the second fixed contact (22) and the outlet terminal (62).

8. The miniature circuit breaker (100) of any of claims 1 to 6, wherein:
the moving contact support (11) is provided with two moving contacts (12) spaced apart from each other, the two moving contacts (12) being respectively matched with two fixed contacts (20), and wherein the two fixed contacts (20) comprise a first fixed contact (21) and a second fixed contact (22), the first fixed contact (21) being electrically connected to an inlet terminal (61) of the miniature circuit breaker (100), and the second fixed contact (22) being electrically connected to an outlet terminal (62) of the miniature circuit breaker (100); and
the current sensor (41) and the coil (31) are both arranged between the first fixed contact (21) and the inlet terminal (61), or the current sensor (41) and the coil (31) are both arranged between the second fixed contact (22) and the outlet terminal (62).

9. The miniature circuit breaker (100) of any of claims 1 to 8, wherein:
when the main circuit current is greater than the first predetermined short-circuit current threshold (Ib), the magnetic trip assembly (30) drives the moving contact (12) to be separated from the fixed contact within a first trip delay time (T1); and
when the main circuit current is greater than the predetermined overload current threshold and less than the first predetermined short-circuit current threshold (Ib), the electronic trip unit (40) drives the moving contact (12) to be separated from the fixed contact (20) within a second trip delay time (T2), and the second trip delay time (T2) is greater than the first trip delay time (T1).

10. The miniature circuit breaker (100) of any of claims 1 to 9, comprising a communication module (70) adapted to send operating parameters of the miniature circuit breaker (100) to the outside.

11. The miniature circuit breaker (100) of claim 10, comprising a housing (90) in which the tripping mechanism (10), the fixed contact (20), the magnetic trip assembly (30), the electronic trip unit (40), and the communication module (70) are disposed, and
the housing (90) is provided with a manual switch operatively connected to the moving contact support (11) and adapted to drive the moving contact (12) to be separated from or abutted against the fixed contact (20).
